Europäisches Patentamt

European Patent Office

Office européen des brevets

(19)

(11) **EP 0 616 731 B1**

(12) **EUROPEAN PATENT SPECIFICATION**

(45) Date of publication and mention
of the grant of the patent:
**23.09.1998 Bulletin 1998/39**

(21) Application number: **92924800.3**

(22) Date of filing: **09.12.1992**

(51) Int Cl.6: **H01L 41/20**

(86) International application number:
**PCT/GB92/02275**

(87) International publication number:
**WO 93/12547 (24.06.1993 Gazette 1993/15)**

(54) **MAGNETOSTRICTIVE MATERIAL**

MAGNETOSTRIKTIVES MATERIAL

MATERIAUX MAGNETOSTRICTIFS

(84) Designated Contracting States:
**AT DE ES FR GB IT NL SE**

(30) Priority: **10.12.1991 GB 9126207**

(43) Date of publication of application:
**28.09.1994 Bulletin 1994/39**

(73) Proprietor: **BRITISH TECHNOLOGY GROUP LIMITED**
**London EC4M 7SB (GB)**

(72) Inventor: **GIBBS, Michael Richard John**
**Paulton, Bristol B518 5XQ (GB)**

(74) Representative: **Neville, Peter Warwick et al**
**Patents Department**
**British Technology Group Ltd**
**10 Fleet Place**
**London EC4M 7SB (GB)**

(56) References cited:
- **INTERNATIONAL MAGNETICS CONFERENCE APRIL 17-20 ,1990,BRIGHTON UK H. SZYMCZAK ET AL. 'Magnetostriction of multilayer Co/Ag films Pg HC-09'**
- **INTERNATIONAL MAGNETICS CONFERENCE APRIL 17-20, 1990, BRIGHTON UK H.AWANO ET AL. 'Magnetostriction and In-Situ measurement of stress of Co/Pd compositionally modulated multilayer films during fabrication Pg HC-08'**

## Description

This invention relates to the production of materials with useful magnetostrictive properties.

Magnetostriction is the property which relates magnetic characteristics of a body of material to a change of the shape of the material. The property is seen in the change in size of bodies of certain materials when the magnetic environment changes or the change in magnetic characteristic when a force is applied to such a body to change its shape. Magnetostriction is a dimensionless quantity represented by the magnetostriction constant $\lambda_S$, relating magnetisation and shape change and in the SI system of units useful values are some tens or hundreds of parts per million, particularly for use in sensors and transducers. For such uses a high magnetomechanical coupling factor is desirable. Also "soft" magnetic properties are generally preferred.

While thin film amorphous alloys and magnetic multilayers individually provide some of the required properties there is still a strong need for a significant improvement in the properties available and for materials which exhibit a useful combination of such properties.

It is an object of the invention to provide materials with improved properties and methods of production of such materials.

In the publication "Magnetostriction of Multilayer Co/Ag Films" by H. Szymczak *et al.,* published at the International Magnetics Conference, April 17-20, 1990, Digest page HC-09, a study is made of cobalt and silver multilayers to sense the presence of any interdiffusion layers at the interfaces, which may cause changes in elastic and magnetoelastic properties of the multilayers, and the magnetostriction constant of the multilayers was measured against inverse layer thickness, but no evidence was presented or discussed to suggest a magnetostriction constant greater than that of naturally-occurring cobalt.

In the publication "Magnetostriction and In-Situ Measurement of Stress in Co/Pd Compositionally Modulated Multilayer Films During Fabrication", by H. Awano *et al.,* published at the International Magnetics Conference, April 17-20, Digest page HC-08, the anisotropy energy of the inverse magnetostriction effect in multilayer films is considered, and the stress at the interface of the films is measured, but it is stated that for a qualitative discussion of magnetostriction effect at the interface, further research is required.

According to the invention as claimed there is provided a magnetic material comprising at least two layers having different atomic structures, being at least one layer of a magnetically soft substance and at least one other layer of a second substance, the other layer having an atomic structure which cooperates with the atomic structure of the magnetically soft layer so as to alter the spacing of the atoms in at least the part of said magnetically soft layer adjacent the other layer whereby a magnetostrictive property of the material is increased, characterised in that the magnetically soft substance is immiscible with the other layer.

Optionally the alteration of the spacing is an increase in the spacing from the usual atomic spacing.

Usually, one layer of the material comprises a magnetic material and the other layer comprises either a magnetic or a non-magnetic material. Optionally the first and second layers comprise magnetic and non-magnetic forms of the same element. At least one of the layers may be an alloy.

The magnetically soft substance may be ferrous, such as Fe or an alloy between Fe and Co. The other layer may be of Ag. There may be a plurality of bilayers each comprising a layer of the first substance and a layer of the second substance, and optionally an insulator such as silicon oxide between bilayers.

The magnetically soft substance may be chosen from the group of ferromagnetic elements of at least iron, nickel, cobalt, gadolinium and terbium.

The non-magnetic substance may be chosen from aluminium, magnesium, gold and silver and silicon oxide.

Preferably there are many first and second layers in the material forming a multilayer material. Generally there will be alternating said first and second layers. One first layer and the overlaid second layer may be identified as a bilayer. A first and second layer may have a third layer associated therewith as a trilayer and may further have a fourth layer associated therewith as a quadlayer. In general the material form can be expressed as of M multilayers each having N component layers. Typically N will be between two and five while M will have a value of a few tens, typically 20 to 50.

There may be a substrate on which the multilayer material is built up. The material may remain on the substrate for use or be released therefrom, for example by chemical means. The substrate may be glass or mica or KAPTON (RTM) or other suitable material. The magnetic material may be prepared in the place of eventual use, for example by deposition of successive component layers on a machine part or like object. There may be more than 30 bilayers.

Each layer of a bilayer may be at least a few nanometres thick, that is a few tens of atoms thick, and may be up to ten or more nanometres thick. It is believed that a well-defined boundary is useful where the second layer is overlaid on the first. This will produce a stress-free strain in the overlaid layer.

One form of the material described above may prepared by a method including overlaying the second substance (component) on the first, providing a well-defined boundary where the second component is contiguous with the first, and causing or producing a stress-free strain in the overlaid component, at least adjacent the first component.

Another form of the material described above may prepared by a method including overlaying the second substance (component) on the first, permitting or causing the second component structure to be influenced by the first to produce said cooperation.

According to a particular aspect of the invention as claimed there is provided a magnetic material of a first component layer and a second component layer overlaid on the first, there being a lattice structure in at least one of said layers and in which magnetic material at least one lattice structure is modified where said first and second component layers are contiguous whereby the magnetostrictive property of the material is enhanced.

There may be an interface region where the layers are contiguous. The modification may be in the interface region. Where the interface region is in an elemental layer the lattice structure in at least said region may be one other than the usual one for the layer element.

According to the invention as claimed there is provided a method of producing a multilayer magnetic material including depositing a first component, causing or permitting a second component to be progressively overlaid on the first, controlling the depositing. of the first component and the overlaying of the second component to produce respective different structures and causing or permitting the structures to cooperate to assist the magnetostrictive behaviour of the material.

The method may include providing a first component layer of a first lattice structure, causing or permitting a second component layer of a second lattice structure to be progessively overlaid on the first, controlling the overlaying of the second component so that at least one component layer in a region contiguous to the interface of the layers has a lattice structure modified by the overlaying action.

The method may include overlaying by sputtering. The method may include overlaying substantially atom-by-atom. The method may include sputtering from a target which may be of one element or of two or more elements to enable the deposit of an alloy.

The method may include causing or permitting the respective different structures to be distinct and form an interface which provides a pseudo free surface.

A multilayer material as described above has an M/H loop characteristic which is altered by distorting the material, for example by bending.

According to a particular aspect of the invention as claimed there is provided a multiple multilayer magnetic material as described above in which the overlaid second layer is covered by an insulating layer, to enhance the frequency response.

According to the invention as claimed there is provided a magnetic material arrangement including a magnetic material as described above and means to cooperate with the material to convey to an external connection a response of the material to an external action.

The response may be a change of permeability or dimension and the external action may be the stressing of the material. The action may be flexure of a support for the material or an ambient pressure change, or an external magnetic field.

The arrangement may form part of an accelerometer, a torque sensor or like device.

Embodiments of the invention will now be described with reference to the following examples and drawings, in which:

Figure 1 shows in schematic form a representation of a lattice structure of a multilayer material according to the invention,

Figure 2 shows in schematic form a representation of another lattice structure of a multilayer material according to the invention,

Figure 3 shows M/H characteristics of a material according to the invention,

Figures 4 and 5 show in schematic form a portion of a multilayer material, after deposition and after subsequent annealing respectively,

Figures 6 to 9 show plots of characteristics of materials embodying the invention,

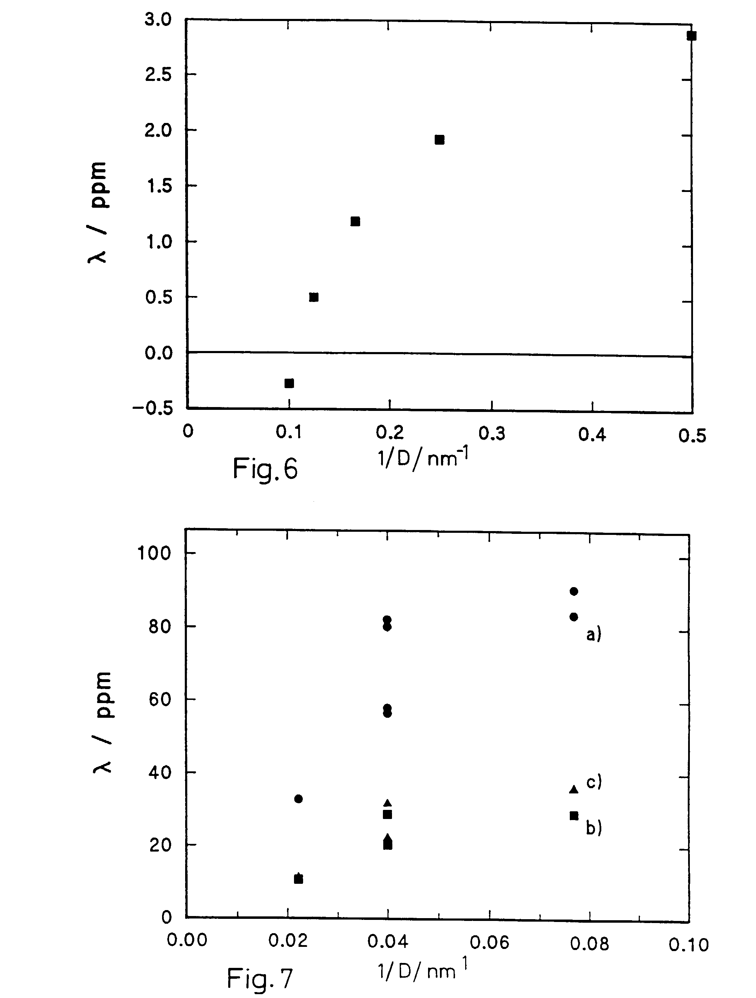

Figure 6 shows magnetostriction constant of Fe/Ag multilayers (S1) versus 1/(modulation period),

Figure 7 shows magnetostriction constant of Fe-Co/Ag multilayers versus 1/(modulation period) calculated using $E_f$ from both the volume average and the vibrating reed correction from equation 5, (squares and circles respectively). Also shown are the effective magnetostriction constants of the alloy layers alone, using the volume average $E_f$ method (triangles),

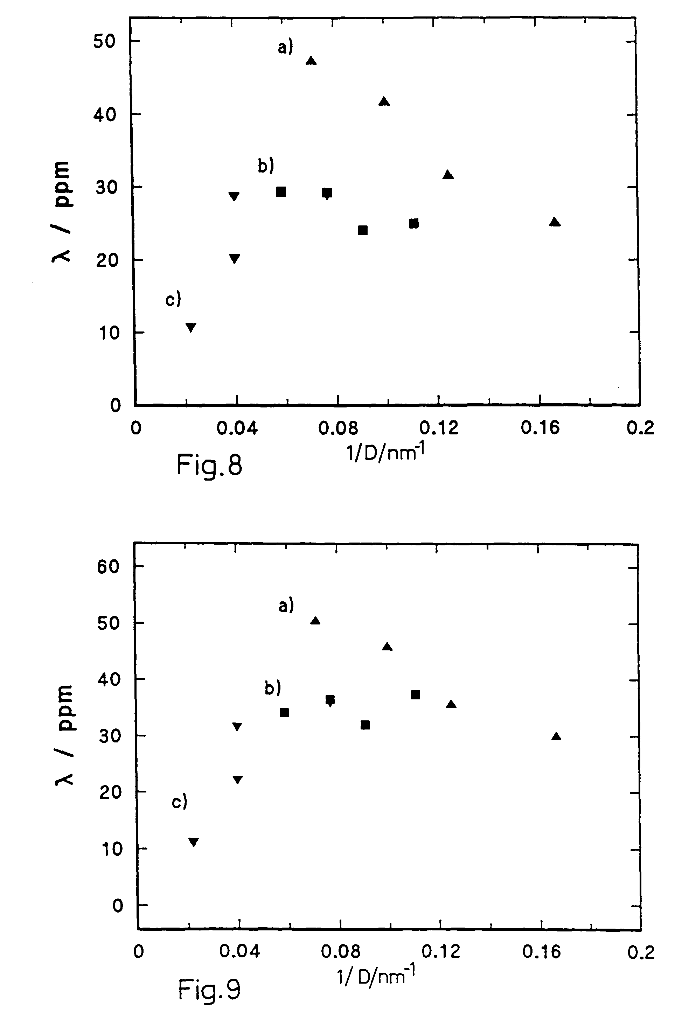

Figure 8 shows magnetostriction constant of Fe-Co/Ag multilayers versus 1/(modulation period),

    a) $t_{Ag}$ = 2 nm (S4),
    b) $t_{Ag}$ = 5 nm (S3),
    c) $t_{Ag}$ = 5 nm, $t_{anneal}$ = 30 minutes (S2),

Figure 9 shows magnetostriction constant of Fe-Co layers within Fe-Co/Ag multilayers versus 1/(modulation period), (a), (b) and (c) as in Figure 8, and

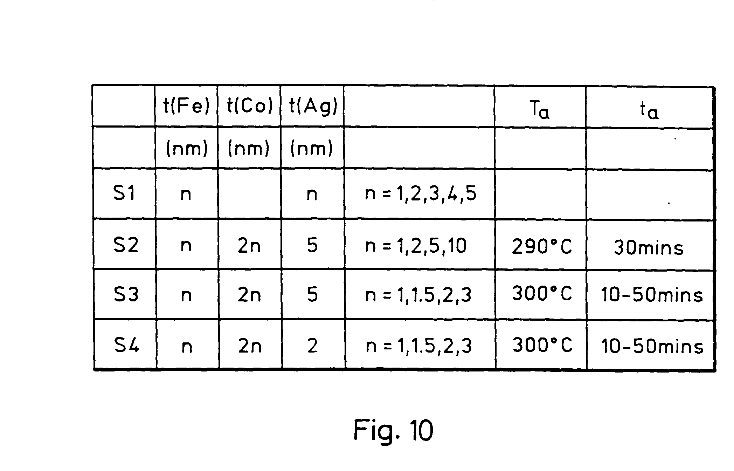

Figure 10 is a table of materials exemplifying the invention.

Various proposals for multilayer materials having magnetic properties have been made, for example de Wit, Witmer and Dirne (Advanced Materials, Vol. 3 (1991) No. 7/8 pp 356 to 360) and Zeper, van Kesteren and Carcia (Advanced Materials, Vol. 3 (1991) No. 7/8 pp 397-399). In the first of these (de Wit, etc) a material with enhanced saturation magnetisation and relative permeability but minimal magnetostriction, specifically for a video recorder read/write head, is described. To achieve this a very small grain size is sought for the magnetic material layer (iron, grain size below 10 nanometres) and to produce such a grain size the iron layers are around 10 nanometres thick. The layers are separated by thinner layers of another ferromagnetic material, specifically an iron/chromium/boron layer. This layer needs to be at least two nanometres thick to prevent the grains in one iron layer linking with those in another iron layer by columnar growth and specifically epitaxial growth is not desired. In the second (Zeper et al) a magneto optical recording material is described, for enhanced recording density, which has adequate Kerr rotation and low enough Curie temperature while having a preferred magnetisation direction perpendicular to the material layer. This preferred direction only occurs with cobalt/platinum or cobalt/palladium multilayers when the cobalt layers are less than some 0.8 to 1.2 nanometres. The thickness of the non-magnetic but magnetically polarisable platinum or palladium layer is set by the required balance of Kerr effect and Curie temperature and for platinum is about 0.9 nanometres with a 0.4 nanometre cobalt layer. The cobalt layer is about two atom layers thick so that the required magnetic anisotropy is not reduced by "bulk" atoms between the surface layers. In Zuberek, Szymczak, Krishnan and Tessier (Journal de Physique, Vol. 12, No. 9, Colloque C8, December 1988, pp 1761 to 1762) it is suggested that a "bilayer" of evaporated component materials depends for effectiveness on the thinness of a nickel layer. In Dirne, Tolboom, de Wit and Witmer (J. Magn. Magn. Mat., No. 83, (1990) pp 399 to 400) the possibility of interface mixing in Fe/Co multilayers is discussed and seen as a disadvantage. Techniques to avoid this disadvantage are suggested.

Multilayers of the present invention as claimed do not follow the techniques of the above proposals. The present invention as claimed provides in one aspect that a layer of a first component overlaid on another layer, of a second component, is caused in a region contiguous with the other layer to adopt a structure other than that of the lattice which it would normally adopt. In this way, which can be described as lattice mismatch, a stress-free strain can be produced in at least the contiguous region of the overlaid layer. A result of this stress-free strain is an enhanced magnetostriction constant, $\lambda_s$.

Typically such layers of a first material overlaid on the second would be arranged as several bilayers on a substrate. Each layer of a bilayer would be some five to fifteen nanometres thick and deposited by sputtering so that atoms being deposited arrive at a rate slow enough to be able to be influenced in deposit position by the existing lattice of the second component layer or that of the first-deposited overlaid first component atoms. Care is needed to avoid building stress into the layers by the thermal effects of sputtering. Some ten to fifty bilayers can be deposited. The overlaid component applied adjacent to the second component lattice is conveniently caused to adopt a lattice spacing appropriate to that of the second component. This will cause a stress-free strain in at least the contiguous region of the overlaid component. The stress-free strain will be best exhibited if there is a sharp boundary between the layers.

If required a pre-stress can be built in to the eventual material by, for example, keeping the substrate hot during deposition of components so that the substrate contracts on cooling. Also a magnetic bias can be built in by including a layer of permanently magnetisable component for example as or immediately above the substrate. A buffer substrate can also be used but care must be taken that the buffer transmits any strain that is applied for action by or on the magnetostrictive material. An inert or insulating layer may be applied to protect the material. Films may be grown under the influence of an imposed magnetic field to enhance the desired effect.

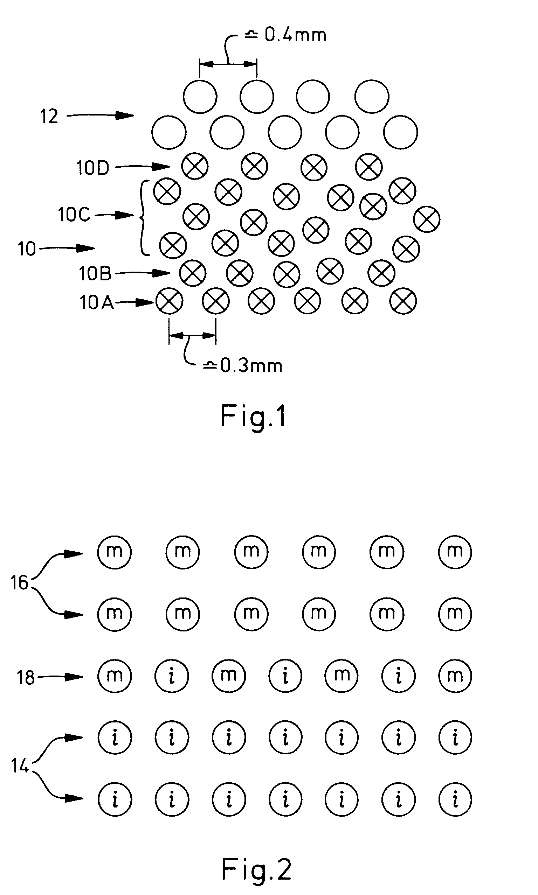

Figure 1 represents in a schematic manner the lattice at and near the surface of the second substance layer 12 and the lattice in the contiguous region of the overlaid substance layer 10. In the Figure overlaid substance atoms are indicated by the smaller, crossed, circles and the second layer substance atoms by the more widely spaced larger, open, circles. The lattice at 10A, furthest from the second substance layer 12, has the normal atomic spacing for the overlaid substance, while at levels 10B, 10C and 10D successively nearer the layer 12, the lattice of the overlaid substance is progressively more expanded.

To investigate the magnetostrictive properties further examples have been prepared. Typically these are a number of alternate layers of magnesium and iron, each a few nanometres thick and having a few tens of bilayers. The layers are not necessarily of the same thickness. The layers are deposited by sputtering from alternately exposed sources using conventional techniques. The preparation is arranged to ensure that bulk effects are not significant. The effect of stress on the film on the shape of the magnetisation/field (M/H) loop was also examined. A small amount of distortion, by bending the specimens, changed the loop shape by a detectable amount, increasing the value of M at lower values of H compared with the loop for the unstressed specimens.

Other structures may be used to achieve the invention as claimed. Certain combinations of overlaid substance layers will produce a degree of alloying and this in turn can produce "dislocations" in an atomic level structure which would otherwise be adopted. Provided one substance layer is magnetic the other can be an insulator as the merging of the layers where they are contiguous can alter the spacing of the magnetic substance layer lattice and thus usefully alter the magnetostrictive property. Figure 2 shows in sketch form this action where, in a lattice 16, atoms of a magnetic substance, identified at $\underline{m}$, are displaced at an interface 18 by the presence of atoms of another substance, identified at $\underline{i}$, which may be non-magnetic even an insulator, in a lattice 14.

The present invention as claimed provides in another aspect an interface effect which can be a relatively sharp lattice mismatch as the overlaid components cannot easily mix.

An insulating layer, for example silicon oxide, can be introduced to produce an improvement in performance, especially an improved high frequency performance. The insulating layer thickness will be dependent on the frequency at which the device is to operate but will also be dependent on the effect of the relative thickness of the insulating layer and the bilayer on the propagation velocities in the insulating and magnetic components. From these considerations it is possible to derive suitable thickness relationships for a particular application of the multilayer material. In general the insulating layer thickness will be several times that of the individual magnetic component layer. In this way magnetostrictive materials with several tri- or quad- layers can be built up, of the general form of L multilayers each having N component layers. At least one of the N component layers will be a magnetic, generally a ferromagnetic, substance such as iron, nickel, cobalt, gadolinium or terbium while another will be a non-magnetic substance and may be a metal or an insulator, examples including aluminium, magnesium gold and silver and silicon oxide. If N is more than two one of the non-magnetic layers can be a metal and another an insulator. A further magnetic component layer may be included. A magneto-electric transducer can be formed by placing structures as exemplified above onto an electrostrictive structure such as PVDF, the dimensional changes in the magnetic structures imposing a strain on the electrostrictive structure, producing an electrical signal related to the action on the magnetostrictive structure.

Further examples of the invention will now be described.

Multilayers are grown using an rf glow discharge sputtering system in a sputter-up configuration with three 15 cm water-cooled magnetron target electrodes on a carousel, and a water-cooled substrate platen electrode which allows the substrate to be pre-sputtered. The substrate platen also has a heater capable of temperatures up to 600°C. The target-substrate distance was set at 60 mm, with an argon plasma pressure of two-thirds of a Pascal (5 mtorr). The sputtering equipment is a NORDIKO machine. The deposition rates were calibrated using a "Talystep" stylus based film thickness measurement instrument. Structural characterisation was also done using X-ray diffraction.

The substrates were glass and Kapton (Registered Trade Mark) (polyimide). The substrate for SAMR measurements (see below) was 25 mm thick Kapton, which was thin enough and had a low enough Young's modulus to avoid overly constraining the films while still being able to support them.

Fe/Ag multilayers were grown with 50 repeats (i.e. 50 bilayers).

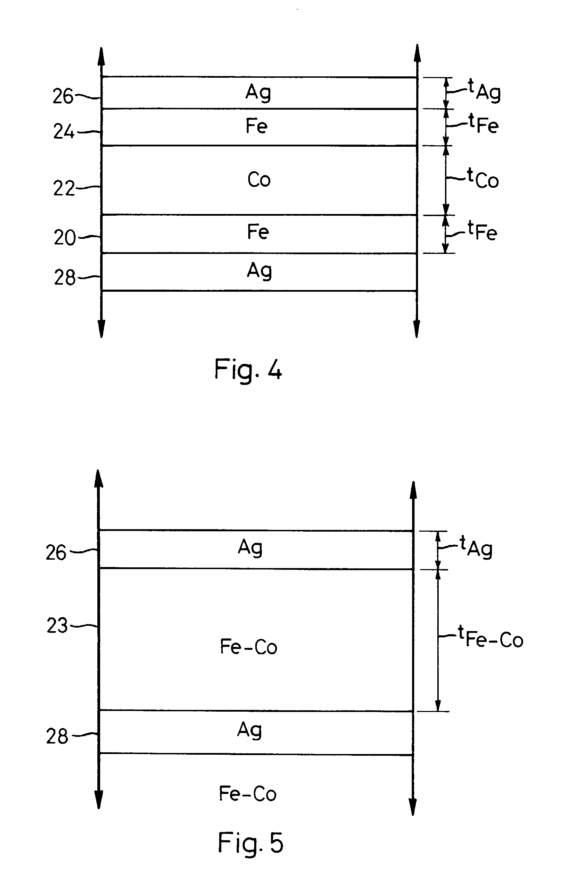

Fe-Co/Ag multilayers (20-26, Figure 4) of 25 repeats (25 bilayers) were grown. The layers of Fe-Co alloy in the Fe-Co/Ag multilayers were produced by growing sandwiches 20-22-24 of Fe/Co/Fe between the silver layers 28 and 26. The multilayer was subsequently annealed to allow interdiffusion of the Fe and Co to form a layer 23 (Figure 5) of alloy of thickness $t(Co)+2t(Fe)$ (the Ag is immiscible with both). The heat treatment was done in a non-inductively wound tube furnace, with the sample laid flat between two glass slides in a vacuum provided by a rotary pump and nitrogen trap to eliminate oxidation. The anneal time and temperature were 30 minutes and 290°C respectively.

A series (S1) of five Fe/Ag multilayers was grown where $t(Fe)=t(Ag)=1,2,3,4,5$ nm.

A series (S2) of Fe/Co/Fe/Ag (i.e. Fe-Co/Ag) multilayers was grown where the thickness of the Co layer was twice that of each of the Fe layers so that the total thickness was the same for both, resulting in a post-anneal alloy of a nominal composition of $Fe_{50}Co_{50}$. The thickness of this layer was varied from 4 to 40 nm and $t(Ag)$ was set at 5 nm. These were subsequently annealed in vacuum for 30 minutes at 290°C. Two other Fe/Co/Fe/Ag (i.e. Fe-Co/Ag) series were grown with silver layer thicknesses of 2 (S4) and 5 (S3) nm. The anneal times were longer for the films with thicker Fe/Co layers because of the greater degree of interdiffusion required. The anneal times (at 300°C) were 10, 20, 30 and 50 minutes for alloy layer thicknesses 4, 6, 8, 12 nm respectively.

As the layer thicknesses are decreased the volume fraction of the interface regions is increased. This increases the proportion of the multilayer material which is formed by atoms at or near the surface of a layer. The local moment is increased in the vicinity of a free surface so the local moment effect is enhanced as the interface volume fraction is increased. The texture of a layer is also significant and its retention can be enhanced by depositing the alloy directly and avoiding or reducing the annealing step. This will also encourage growth of the alloy in the [110] direction normal to the layer.

The coercive fields of Fe-Co/Ag multilayers are between 1 and 2 $kAm^{-1}$, reducing with layer thickness. Generally, the annealing rendered the multilayers magnetically softer. Also by annealing the multilayers were stress-relieved and the iron and cobalt layers were caused to mix more thoroughly. The interfaces with silver were probably sharpened, since silver is immiscible with iron and with cobalt. For the thinnest iron and cobalt layers (D=9nm, i.e. $t_{Co}=2nm$) the region between silver layers would have been almost completely alloyed as-deposited [Dirne and Denissen, 1989]. Annealing this multilayer increased (approximately doubling) its coercive field in distinction to the other multilayers, and it became impossible to measure the magnetostriction. This is considered below.

The length of an anneal required to achieve complete alloying at a given temperature will depend on the thickness of the component layers. Thus it is possible that the anneals did not completely alloy the layers, especially in the thicker multilayers, and that they were longer than required for the thinner multilayers. The optimum heat treatment may not have been used.

Magnetostriction measurements were made using the Small Angle Magnetisation Rotation method proposed by Norita et al. [1980] and widely used on amorphous ribbons.

The basic principle of the method is as follows: the sample to be measured is saturated in the longitudinal direction (z) by a large dc field. A smaller ac field of frequency $\omega$ acts in the transverse direction (y). This results in a small degree of rotation of the macroscopic moment direction about the longitudinal direction. If a stress, $\sigma$, is also applied to the sample along this direction, the angle of moment rotation is given by

$$\theta = \frac{\mu_o M_s H_y}{H_z + H_d + H_\sigma} \tag{1}$$

where $H_d$ is the demagnetising field due to the sample shape, and $H_\sigma$ is the stress-induced anisotropy field. This is given by

$$H_\sigma = \frac{3\lambda_s \sigma}{\mu_o M_s} \tag{2}$$

The sample is mounted within a search coil whose axis is in the longitudinal direction. Thus a rotation of the magnetisation about this axis results in an induced ac voltage across the search coil with frequency $2\omega$, $V_{2\omega}$.

A change in the stress on a magnetostrictive material effects a change in the stress induced anisotropy field. In the case of a positively magnetostrictive material, a tensile stress tends to make the stress axis magnetically easier, so aligning the moments towards this axis. This would cause the angle of moment rotation to decrease, so decreasing the search coil output voltage.

This change in output voltage can be compensated by adjustment of the dc field, $H_z$. The change in $H_z$ is then equal to the change in $H_\sigma$. Thus, the magnetostriction constant, $\lambda_s$, is generally determined by plotting the change in $H_z$ for a series of applied stresses, so that (where moment rotation is small)

$$\lambda_s = \frac{\mu_o M_s dH_z}{3\, d\sigma_a} \mid V_{2\omega}, H_y. \tag{3}$$

The multilayers are too thin to be self supporting and need to be measured while still on their substrates. Although these can have elastic moduli far lower than the multilayers, they are much thicker and so accommodate a significant proportion of the stress, so it is necessary to correct for their presence.

This correction can be made by assuming that the multilayer is strongly adhered to the substrate so that they strain by the same amount and that the Young's modulus, E, of the whole is equal to the volume average of the component layers and the substrate. This assumes that the reed as a whole (i.e. substrate + multilayer) is effectively homogeneous. In this case the magnetostriction is given by

$$\lambda_s = \frac{\mu_o M_s}{3} \left[ \frac{E_{av} A_{f+s}}{E_f} \right] \frac{dH_z}{d\sigma_a} \mid V_{2\omega}, H_y. \tag{4}$$

The same method of correction was also used by Wenda et al. [1987] on measurements of FeB and FeSiB single films sputtered onto polyester substrates.

Measurements of multilayer samples were taken on two slightly different SAMR apparatus arrangements. The dc field was applied using a solenoid, while the ac field was applied with a pair of Helmholtz coils. The sample was placed within a search coil (4000 turns) coaxially with the solenoid, in the centre of the Helmholtz coils. In the second configuration, a second, "bucking", coil was also present and was backed off against the search coil to cancel out any induced voltages common to both, i.e. due to sources other than the sample magnetisation.

The sample was clamped at both ends. The clamp at one end was fixed while that at the opposite end was connected to a cable which was loaded with known weights. The dc field was determined from the product of the current and the number of turns per unit length in the solenoid.

The values of $B_S$ were obtained from literature, namely 2.0T for iron and 2.3T for $Fe_{50}Co_{50}$ alloy. The value of $B_S$ for the whole multilayer was simply $B_S$ for the relevant magnetic layer multiplied by its volume fraction.

The Young's modulus of the multilayers was measured using the vibrating reed method, which is fully described in Berry and Pritchet [1975]. It is based on the measurement of the resonant frequencies of various modes of cantilever vibration, $f_n$, of reeds clamped at one end.

Reeds were cut from the multilayer using a sharp blade and had free lengths and widths of approximately 13-20 mm and 1 mm respectively.

The value of E for the multilayer can be obtained from the value for the reed from the expression (from Berry and Pritchet):

$$\frac{f^2_{reed}}{f^2_{substrate}} = 1 + \frac{t}{d}\left[\frac{3E_f}{E_s} - \frac{\rho_f}{\rho_s}\right], \qquad (5)$$

where the subscripts f and s refer to the multilayer and substrate respectively, and t and d are the multilayer and reed thicknesses (t«d).

The value of $\lambda_S$ for the multilayer was calculated from equation 4. In the case of the Fe-Co/Ag multilayers (t(Co) =2t(Fe)), two data sets are presented, corresponding to the two methods of calculating $E_f$. For the Fe/Ag data, only the values of $\lambda_S$ derived from the assumption of a volume average $E_f$ are shown.

The data for $\lambda_S$ is shown versus the reciprocal of the modulation period, D, in Figure 6. At 1/D=0 the value of $\lambda_S$ should be that for bulk iron. The bulk value of $\lambda_S$ of polycrystalline iron is -7 ppm, although this becomes more positive as it becomes more textured, so that perfectly textured polycrystalline iron with the [110] direction normal to the film surface has a value of $\lambda_S$ of approximately 14 ppm. In practice, the measured value of $\lambda_S$ for a single iron film will generally lie between these two values. As a check a thick (0.8 µm) iron film was deposited onto each side of a Kapton susbtrate (1.6 pm total). $\lambda_S$ was measured to be -3.0 ppm.

As D decreases so that the volume fraction of the Fe/Ag interface layers increases, it is found that $\lambda_S$ becomes more positive. Hence the presence of silver is seen to enhance the value of $\lambda_S$ in iron, as expected.

A series of multilayers was grown with layers of Fe and Co of equal thickness (5 nm) with silver layers of varying thickness. Because there was approximately twice the amount of iron as cobalt in the alloy layer after annealing, it is probable that there was a composition gradient across the layer, with a corresponding variation in $\lambda_S$. The $\lambda_S$ data from this series of multilayers did not show any systematic trend and there was a wide scatter in the data and is therefore not shown here.

The $\lambda_S$ data for the second series of multilayers is shown for these films versus the reciprocal of the modulation period in Figure 7. Also shown is the effective $\lambda_S$ of the magnetostrictive material alone, derived via the data assuming a volume average Young's modulus. There are pairs of data points obtained via the Berry and Pritchet $E_f$ correction method for most samples, corresponding to two values of $E_f$ obtained from the third and fourth modes of reed vibration. There are two samples measured with t(alloy)=30 nm since two sections were taken from the same substrate and were annealed independently. However, $E_{reed}$ for this sample was only measured using a reed from one of the anneals, so the pair of points from this sample with the higher $\lambda_S$ values may be subject to large error. This figure illustrates the difference in the data resulting from the two methods of correction of the Young's modulus.

Before anneal, most samples were found to have small negative magnetostriction (generally smaller than -5 ppm), and large positive $\lambda_S$ after anneal confirming that alloying of the component TM layers had alloyed. The sample with t(alloy)=4 nm gave a large positive $\lambda_S$ before annealing, indicating that the iron and cobalt layers had intermixed to a high degree. It is suggested in Dirne and Denissen [1989] that Fe-Co alloys form at interfaces during deposition, with thicknesses of approximately 1 nm This means that approximately 50% of the Fe-Co in this sample was intermixed before anneal. Unfortunately, no SAMR response could be obtained from the sample after anneal. As stated earlier, this was accompanied by a remarkable increase in coercive field. It may be that since the layers were so thin, the anneal caused disruption of the coherency of the multilayer.

From the volume average data, it is seen that $\lambda_S$ of the multilayer increases to approximately 20 ppm as the alloy thickness is reduced to 8 nm, equivalent to a value of $\lambda_S$ of about 36 ppm for the alloy layers.

The magnetostriction of all three series (S2, S3, S4) of the Fe-Co/Ag multilayers were measured and are shown in Figure 8. These values were calculated using the volume average Young's moduli. The corresponding values of $\lambda_S$ for the alloy alone are shown in Figure 9. A clear trend is seen for the series of multilayers (S4) with $t_{Ag}$=2 nm, where

$\lambda_S$ decreases with decreasing alloy layer thickness. The data for the series of multilayers with $t_{Ag}$=5 nm also show some reduction of $\lambda_S$ with $t_{Fe-Co}$, but in Figure 8, the values of $\lambda_S$ for the alloys are approximately constant (within error), indicating that the reduction in $\lambda_S$ for the multilayer is due to loading by the silver layers. The reduction in $\lambda_S$ for the $t_{Ag}$ data set cannot be accounted for in this way.

The decrease of $\lambda_S$ of the thicker multilayers from the series (S2) is thought to be due to the iron and cobalt layers not fully intermixing during the half-hour anneal. It should be noted that the values of $\lambda_S$ for the two multilayers comprising layers of 2 nm Fe, 4 nm Co and 5 nm Ag, annealed at approximately 300°C for 30 minutes were measured to be the same within error. This adds confidence to the repeatability and accuracy of the data. If intermixing is poor composition gradients can arise.

The value of $\lambda_S$ of the alloy layer was measured to be approximately 35±3 ppm. This compares with approximately 80 ppm for the bulk. A multilayer of Fe/Co was deposited without silver layers, and was annealed nominally to form a single layer (0.5 µm total thickness) of Fe-Co alloy, $T_a$=300°C, $t_a$=30 minutes. The value of $\lambda_S$ of the film was measured to be 43 ppm. A further heat treatment of 30 minutes at 300°C was found to cause an increase in $\lambda_S$ to approximately 65 ppm.

The magnetostriction constant obtained from SAMR values depends on the Young's modulus of the reed and also on that of the film only. Discrepancies have arisen between the values of $E_{flim}$ corrected from $E_{reed}$ from two different methods of obtaining this correction. The method assuming a volume average of the moduli is thought to be the more reliable.

The values of $\lambda_S$ of the Fe/Co/Fe/Ag multilayers were small and negative, as would be expected from an average of Fe and Co. After anneal, the $\lambda_S$ values were large and positive, indicating that the Fe and Co had alloyed to a large extent. Annealing also had the effect of making the films softer, predominantly due to relief of internal stresses. Values of $H_C$ of the post-anneal samples were typically of the order of IkA/m.

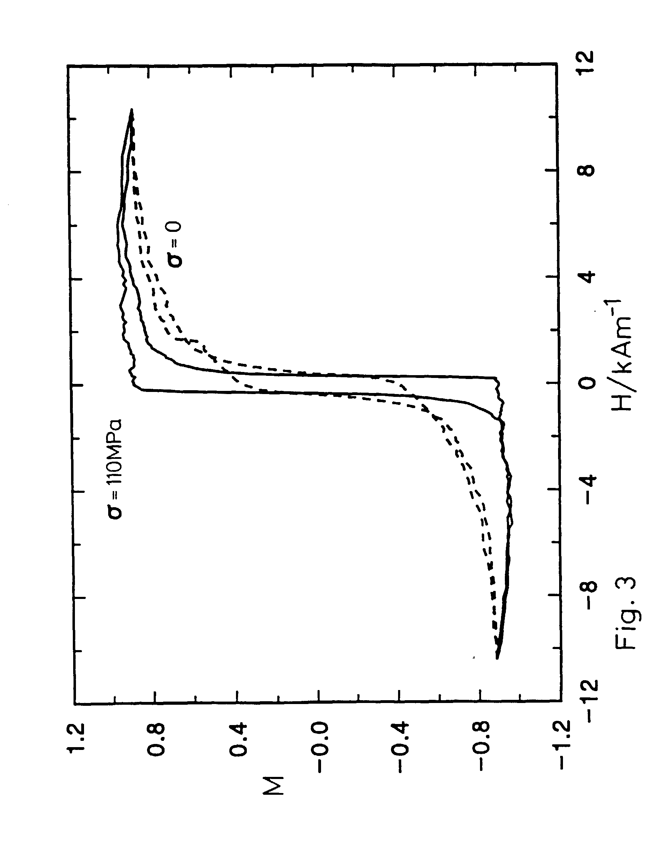

Figure 3 shows the effect of stress on the M/H loop for one of the multilayers from series S4. The specific one used is that where n = 3. The multilayer had 25 bilayers, each deposited as 3 nm Fe/6 nm Co/3 nm Fe/2 nm Ag, supported on a 25 micrometre Kapton layer. Annealing was 50 minutes at 300°C under vacuum. The dotted line is the M/H characteristic at stress σ = 0. When a stress of 110 MPa is applied the shape and size of the M/H loop changes very significantly, shown in the solid line. M is in arbitrary units.

In the case of the Fe/Ag multilayers, reduction in the thickness of the layers (i.e. an increase in the volume fraction of the interface regions) has the effect of making the magnetostriction more positive. The measured values of $\lambda_S$ in this study increased from approximately -0.3 ppm for 5 nm Fe/5 nm Ag to approximately +3 ppm for 1 nm Fe/1 nm Ag. This is consistent with an increase in the local magnetic moment of iron at the Fe-Ag interfaces.

In the case of the Fe-Co multilayers, $\lambda_S$ was seen to decrease with decreasing modulation period, where this was shown to be due to mechanical loading by the silver layers, where $t_{Ag}$=5 nm. When this correction was made, the value of $\lambda_{Fe-Co}$ were found to be approximately 35 ppm, which is considerably lower than those of bulk Fe-Co alloys. Non-optimal heat treatments are thought to contribute to the reduction in the values, as indicated by the decrease in $\lambda_S$ for the thicker multilayers annealed for 30 minutes. A definite decrease in $\lambda_S$ with decreasing alloy layer thickness was seen for the multilayers where $t_{Ag}$=2 nm, which cannot be accounted for by the loading by the silver layers. The reason for this is not clear. It is possible that the silver layers are so thin that the alloy layers have percolated through, especially where these are appreciably thicker than the silver, so that the parameters of the multilayer approach those of a bulk material. It may be that inclusion of silver in the multilayer causes a reduction in $X_{Fe-Co}$.

It is seen from the above that thickness and crystallographic texturing of the alloy layer and silver layer loading all can affect the value of $\lambda_S$. Those skilled in the art will be able to proceed on the basis of the techniques set out above to produce multilayers with significant values of $\lambda_S$ using appropriate component layers and dimensions.

Some of the above examples show that the technique of causing a magnetic component layer to adopt, in a surface region at least, a lattice structure other than the one it would normally adopt produces a magnetic material which exhibits a non-zero magnetostrictive coefficient, albeit at a coercivity more appropriate to a "hard" magnetic material than a "soft" one, but noting that this parameter was not controlled.

Others of the above examples show that the technique of causing a sharp lattice mismatch in overlaid component layers produces a magnetic material which exhibits a non-zero magnetostrictive coefficient. In particular a sharp lattice mismatch, such as occurs with immiscible component layers, can produce a pseudo free surface. The term pseudo free surface is used to describe the arrangement where the surface of a thin layer can emulate a free surface although another layer is contiguous.

The magnetic material can be used in sensing devices, such as pressure gauges, accelerometers and torque sensors, by attaching the material to a structure or by depositing the material in the place where it is to be used.

## Claims

1. A magnetic material comprising at least two layers (10, 12) having different atomic structures, being at least one layer (10) of a magnetically soft substance and at least one other layer (12) of a second substance, the other layer (12) having an atomic structure which cooperates with the atomic structure of the magnetically soft layer (10) so as to alter the spacing of the atoms in at least the part (10D) of said magnetically soft layer (10) adjacent the other layer (12) whereby a magnetostrictive property of the material is increased, characterised in that the magnetically soft substance is immiscible with the other layer.

2. A material according to claim 1 characterised in that the alteration of the spacing is an increase (10D) in the spacing from the usual atomic spacing (10A, 10B).

3. A material according to claim 1 or 2 characterised in that at least one of the one and other layers (23, 26) comprises an alloy (23).

4. A material according to claim 3 characterised in that the one and the other layer comprise magnetic and non-magnetic forms of the same element.

5. A material according to any preceding claim, wherein the magnetically soft substance (10) is ferrous.

6. A material according to claim 5, wherein the ferrous substance is Fe or an alloy between Fe and Co.

7. A material according to any preceding claim, wherein the said other layer (12) is of Ag.

8. A material according to any preceding claim, characterised in that there is a plurality of bilayers (10, 12), each bilayer comprising a layer (10) of a magnetically soft substance and a layer (12) of the second substance.

9. A material according to claim 8, further comprising an insulator between bilayers.

10. A material according to claim 9, wherein the insulator is silicon oxide.

11. A method of preparing a magnetic material according to any preceding claim, characterised by comprising preparing a layer (12) of a first substance and overlayering a layer (10) of the second substance on the first layer whereby the atomic structure of the second layer is altered by the atomic structure of the first layer at least in the part of the second layer (10D) adjacent the first layer (12), and a magnetostrictive property of the material is increased.

12. A method according to claim 11 characterised in that at least the step of overlayering comprises a sputtering process.

13. A method according to claim 12 characterised in that at least the step of overlayering comprises an atom-by-atom deposition process.

14. A method according to any of claims 11 to 13 characterised by further comprising the steps of overlayering the layer of the second substance with further consecutive layers of the first and second substances, the steps being such that the atomic structure of at least each second layer is altered by the atomic structure of the previously-overlayered first layer.

15. A method according to any of claims 11 to 13 characterised by further comprising the steps of overlayering the second layer (22) with a further layer of the first substance (24), the first and second substances being capable of forming an alloy; overlayering the further layer of the first substance (24) with a layer of a third substance (26); and annealing the magnetic material so that the first and second layers form a layer of an alloy (23) on the layer of the third substance (26).

16. A method according to any of claims 11 to 13 characterised in that the layer of the first substance is prepared on a substrate.

17. A method according to claim 16 characterised in that the substrate is a machine part.

18. A magnetostrictive device comprising a magnetostrictive component and sensing means to sense a magnetostrictive change in said component in response to an external physical effect, characterised in that said component is a magnetic material which is according to any of claims 1 to 10.

19. A magnetostrictive device according to claim 18 in which the sensing means senses a change in magnetic permeability of the magnetostrictive component.

20. A magnetostrictive device according to claim 18 in which the sensing means senses a change in a dimension of the magnetostrictive component.

21. A magnetostrictive device according to claim 18 which is an accelerometer.

22. A magnetostrictive device according to claim 18 which is a torque sensor.

23. A magnetostrictive device according to claim 18 which is a pressure gauge.


**Patentansprüche**

1. Magnetisches Material, das wenigstens zwei Schichten (10, 12) mit unterschiedlichen Atomstrukturen umfaßt, wobei es sich um wenigstens eine Schicht (10) aus einer magnetisch weichen Substanz und wenigstens eine andere Schicht (12) aus einer zweiten Substanz handelt, die andere Schicht (12) eine Atomstruktur aufweist, die mit der Atomstruktur der magnetisch weichen Schicht (10) so zusammenwirkt, daß der Abstand der Atome in wenigstens dem Teil (10D) der magnetisch weichen Schicht (10) angrenzend an die andere Schicht (12) geändert wird, wodurch eine magnetostriktive Eigenschaft des Materials erhöht wird, dadurch gekennzeichnet, daß die magnetisch weiche Substanz unmischbar mit der anderen Schicht ist.

2. Material nach Anspruch 1, dadurch gekennzeichnet, daß die Änderung des Abstands eine Erhöhung (10D) des Abstands gegenüber dem gewöhnlichen Atomabstand (10A, 10B) ist.

3. Material nach Anspruch 1 oder 2, dadurch gekennzeichnet, daß wenigstens eine der einen und anderen Schichten (23, 26) eine Legierung (23) umfaßt.

4. Material nach Anspruch 3, dadurch gekennzeichnet, daß die eine und die andere Schicht magnetische und nicht magnetische Formen desselben Elements beinhalten.

5. Material nach jedem der vorangehenden Ansprüche, worin die magnetisch weiche Substanz (10) ein Eisenmaterial ist.

6. Material nach Anspruch 5, worin die Eisensubstanz Fe oder eine Legierung zwischen Fe und Co ist.

7. Material nach jedem der vorangehenden Ansprüche, worin die andere Schicht (12) aus Ag besteht.

8. Material nach jedem der vorangehenden Ansprüche, dadurch gekennzeichnet, daß eine Mehrzahl von Doppelschichten (10, 12) vorhanden ist, wobei jede Doppelschicht eine Schicht (10) aus einer magnetisch weichen Substanz und eine Schicht (12) aus der zweiten Substanz umfaßt.

9. Material nach Anspruch 8, das ferner einen Isolator zwischen Doppelschichten umfaßt.

10. Material nach Anspruch 9, worin es sich bei dem Isolator um Siliziumoxid handelt.

11. Verfahren zum Herstellen eines magnetischen Materials nach jedem der vorangehenden Ansprüche, dadurch gekennzeichnet, daß es umfaßt: Herstellen einer Schicht (12) aus einer ersten Substanz und Schichten einer Schicht (10) aus der zweiten Substanz auf die erste Schicht, wodurch die Atomstruktur der zweiten Schicht durch die Atomstruktur der ersten Schicht wenigstens in dem an die erste Schicht (12) angrenzenden Teil der zweiten Schicht (10D) geändert wird, und eine magnetostriktive Eigenschaft des Materials erhöht wird.

12. Verfahren nach Anspruch 11, dadurch gekennzeichnet, daß wenigstens der Schritt Schichten einen Sputterprozeß umfaßt.

13. Verfahren nach Anspruch 12, dadurch gekennzeichnet, daß wenigstens der Schritt Schichten einen Abscheideprozeß Atom für Atom umfaßt.

14. Verfahren nach jedem der Ansprüche 11 bis 13, dadurch gekennzeichnet, daß es ferner die Schritte Schichten weiterer aufeinanderfolgender Schichten aus den ersten und zweiten Substanzen auf die Schicht aus der zweiten Substanz umfaßt, wobei die Schritte derart sind, daß die Atomstruktur wenigstens jeder zweiten Schicht durch die Atomstruktur der vorher aufgeschichteten ersten Schicht geändert wird.

15. Verfahren nach jedem der Ansprüche 11 bis 13, dadurch gekennzeichnet, daß es ferner die Schritte Schichten einer weiteren Schicht aus der ersten Substanz (24) auf die zweite Schicht (22), wobei die ersten und zweiten Substanzen in der Lage sind, eine Legierung zu bilden; Schichten einer Schicht aus einer dritten Substanz (26) auf die weitere Schicht aus der ersten Substanz (24); und Tempern des magnetischen Materials, so daß die ersten und zweiten Schichten eine Schicht aus einer Legierung (23) auf der Schicht aus der dritten Substanz (26) bilden, umfaßt.

16. Verfahren nach jedem der Ansprüche 11 bis 13, dadurch gekennzeichnet, daß die Schicht aus der ersten Substanz auf einem Substrat hergestellt wird.

17. Verfahren nach Anspruch 16, dadurch gekennzeichnet, daß das Substrat ein Maschinenteil ist.

18. Magnetostriktive Vorrichtung, die eine magnetostriktive Komponente und eine Aufnehmereinrichtung umfaßt, um eine magnetostriktive Änderung in der Komponente auf einen externen physikalischen Effekt hin aufzunehmen, dadurch gekennzeichnet, daß die Komponente ein magnetisches Material nach jedem der Ansprüche 1 bis 10 ist.

19. Magnetostriktive Vorrichtung nach Anspruch 18, in der die Aufnehmereinrichtung eine Änderung der magnetischen Permeabilität der magnetostriktiven Komponente aufnimmt.

20. Magnetostriktive Vorrichtung nach Anspruch 18, in der die Aufnehmereinrichtung eine Änderung einer Dimension der magnetostriktiven Komponente aufnimmt.

21. Magnetostriktive Vorrichtung nach Anspruch 18, die ein Beschleunigungsmesser ist.

22. Magnetostriktive Vorrichtung nach Anspruch 18, die ein Drehmomentsensor ist.

23. Magnetostriktive Vorrichtung nach Anspruch 18, die ein Druckmesser ist.

**Revendications**

1. Matériau magnétique comportant au moins deux couches (10, 12) ayant des structures atomiques différentes, constituées d'au moins une première couche (10) de substance magnétique douce et d'au moins une autre couche (12) d'une deuxième substance, l'autre couche (12) ayant une structure atomique qui agit en commun avec la structure atomique de la couche magnétique douce (10) de manière à modifier l'espacement entre les atomes dans au moins la partie (10D) de ladite couche magnétique douce (10) adjacente à l'autre couche (12) de sorte qu'une propriété magnétostrictive du matériau est augmentée, caractérisé en ce que la substance magnétique douce n'est pas miscible à l'autre couche.

2. Matériau selon la revendication 1, caractérisé en ce que la modification de l'espacement est une augmentation (10D) de l'espacement par rapport à l'espacement atomique habituel (10A, 10B).

3. Matériau selon la revendication 1 ou 2, caractérisé en ce qu'au moins une couche parmi la première et l'autre couche (23, 26) est constituée d'un alliage (23).

4. Matériau selon la revendication 3, caractérisé en ce que la première et l'autre couche sont constituées de formes magnétique et non-magnétique du même élément.

5. Matériau selon l'une quelconque des revendications précédentes, dans lequel la substance magnétique douce (10) est une substance ferreuse.

6. Matériau selon la revendication 5, dans lequel la substance ferreuse est Fe ou un alliage de Fe et de Co.

7. Matériau selon l'une quelconque des revendications précédentes, dans lequel ladite autre couche (12) est constituée d'Ag.

8. Matériau selon l'une quelconque des revendications précédentes, caractérisé en ce qu'il y a une pluralité de doubles couches (10, 12), chaque double couche comportant une couche (10) constituée d'une substance magnétique douce et une couche (12) constituée de la deuxième substance.

9. Matériau selon la revendication 8, comportant de plus un isolant entre les doubles couches.

10. Matériau selon la revendication 9, dans lequel l'isolant est un oxyde de silicium.

11. Procédé de préparation d'un matériau magnétique selon l'une quelconque des revendications précédentes, caractérisé en ce qu'il consiste à préparer une couche (12) constituée d'une première substance et à recouvrir une couche (10) constituée de la deuxième substance sur la première couche de sorte que la structure atomique de la seconde couche soit modifiée par la structure atomique de la première couche au moins dans la partie de la seconde couche (10D) adjacente à la première couche (12), et qu'une propriété magnétostrictive du matériau soit augmentée.

12. Procédé selon la revendication 11, caractérisé en ce qu'au moins l'étape de recouvrement est constituée d'un processus de pulvérisation cathodique.

13. Procédé selon la revendication 12, caractérisé en ce qu'au moins l'étape de recouvrement est constituée d'un processus de dépôt atome par atome.

14. Procédé selon l'une quelconque des revendications 11 à 13, caractérisé en ce qu'il comporte de plus les étapes consistant à recouvrir la couche constituée de la deuxième substance par d'autres couches consécutives constituées des première et deuxième substances, les étapes étant telles que la structure atomique d'au moins chaque seconde couche est modifiée par la structure atomique de la première couche recouverte précédemment.

15. Procédé selon l'une quelconque des revendications 11 à 13, caractérisé en ce qu'il comporte de plus les étapes consistant à recouvrir la seconde couche (22) par une couche supplémentaire constituée de la première substance (24), les première et deuxième substances étant capable de former un alliage, à recouvrir la couche supplémentaire constituée de la première substance (24) par une couche constituée d'une troisième substance (26), et à recuire le matériau magnétique de sorte que les première et seconde couches forment une couche constituée d'un alliage (23) sur la couche constituée de la troisième substance (26).

16. Procédé selon l'une quelconque des revendications 11 à 13, caractérisé en ce que la couche constituée de la première substance est préparée sur un substrat.

17. Procédé selon la revendication 16, caractérisé en ce que le substrat est une pièce de machine.

18. Dispositif magnétostrictif comportant un composant magnétostrictif et des moyens de détection pour détecter un changement de magnétostriction dans ledit composant en réponse à un effet physique extérieur, caractérisé en ce que ledit composant est un matériau magnétique qui est conforme à l'une quelconque des revendications 1 à 10.

19. Dispositif magnétostrictif selon la revendication 18, dans lequel les moyens de détection détectent un changement de perméabilité magnétique du composant magnétostrictif.

20. Dispositif magnétostrictif selon la revendication 18, dans lequel les moyens de détection détectent un changement de dimension du composant magnétostrictif.

21. Dispositif magnétostrictif selon la revendication 18 qui est un accéléromètre.

**22.** Dispositif magnétostrictif selon la revendication 18 qui est un détecteur de couple.

**23.** Dispositif magnétostrictif selon la revendication 18 qui est un manomètre.

EP 0 616 731 B1

≃ 0.4mm

12

10D

10C

10

10B

10A

≃0.3mm

Fig.1

16

18

14

Fig.2

14

Fig. 3

EP 0 616 731 B1

Fig. 4

Fig. 5

16

Fig.6

Fig. 7

Fig.8

Fig.9

| | t(Fe) | t(Co) | t(Ag) | | $T_a$ | $t_a$ |
|---|---|---|---|---|---|---|
| | (nm) | (nm) | (nm) | | | |
| S1 | n | | n | n = 1,2,3,4,5 | | |
| S2 | n | 2n | 5 | n = 1,2,5,10 | 290°C | 30mins |
| S3 | n | 2n | 5 | n = 1,1.5,2,3 | 300°C | 10-50mins |
| S4 | n | 2n | 2 | n = 1,1.5,2,3 | 300°C | 10-50mins |

Fig. 10